# EUROPÄISCHE PATENTSCHRIFT

(11) **EP 1 751 800 B1**
(45) Veröffentlichungstag und Bekanntmachung des Hinweises auf die Patenterteilung: **26.03.2008**
(21) Anmeldenummer: 05754592.3
(22) Anmeldetag: 01.06.2005
(51) Int. Cl.: H01L 27/092

(54) **VERFAHREN ZUM LÖSCHEN VON IN EINER SCHALTUNG AUFTRETENDEN LATCH-UPS SOWIE ANORDNUNGEN ZUM DURCHFÜHREN DES VERFAHRENS**
METHOD FOR SUPPRESSING LATCH-UPS OCCURRING IN A CIRCUIT, AND SYSTEMS FOR CARRYING OUT SAID METHOD
PROCEDE PERMETTANT D'EFFACER DES VERROUILLAGES A L'ETAT PASSANT SURVENANT DANS UN CIRCUIT ET DISPOSITIFS CORRESPONDANTS

(30) Priorität: 01.06.2004 DE 102004026939
(43) Veröffentlichungstag der Anmeldung: 14.02.2007
(73) Patentinhaber: Deutsches Zentrum für Luft- und Raumfahrt e.V., 51147 Köln (DE)
(72) Erfinder: GRUBER, Robin, 81371 München (DE); SCHOTT, Jörg, 82205 Gilching (DE); TEGTMEIER, Bernd, 31737 Rinteln (DE)
(74) Vertreter: von Kirschbaum, Albrecht
(86) Internationale Anmeldenummer: PCT/EP2005/005885
(87) Internationale Veröffentlichungsnummer: WO 2005/119777

(56) Entgegenhaltungen:
- EP-A- 0 175 152
- EP-A- 0 372 842
- EP-A- 0 391 672
- US-B1- 6 184 664

## Beschreibung

### Technisches Gebiet

Die Erfindung betrifft ein Verfahren zum Löschen von in einer Schaltung auftretenden Latch-Ups, wobei bei strombegrenzter Versorgungsspannung eine Unterspannung detektiert wird, nach Detektieren eines Latch-Up die Versorgungsspannung abgeschaltet und in der Schaltung befindliche Ladung abgebaut wird.

Ferner betrifft die Erfindung Anordnungen zum Durchführen des Verfahrens zum Schutz von strahlungsempfindlichen aktiven Schaltungskomponenten einer elektronischen Schaltung.

### Stand der Technik

Derartige Anordnungen sind beispielsweise aus US-B-6,064,555, EP-A-372 842, EP-A-175 152, US-B-6 184 664 und EP 391 672 bekannt.

In Anwendungsbereichen für elektronische Schaltungen, in denen aufgrund der Umgebungsbedingungen hohe Strahlendosen erwartet werden und trotzdem eine lange Haltbarkeit gefordert wird, wie beispielsweise bei Anwendungen im Weltraum, werden derzeit strahlungsresistente Schaltungskomponenten eingesetzt. Solche strahlungsresistenten Schaltungskomponenten haben den Nachteil, dass sie zum einen erheblich teurer sind als vergleichbare, nicht strahlungsresistente Schaltungskomponenten und zum anderen nicht jeder gewünschte Integrationsgrad bzw. Schaltungskomponententyp in strahlungsfester Ausführung erhältlich ist.

Bei Bestrahlung mit hohen Strahlungsdosen zeigen strahlungsempfindliche aktive Schaltungskomponenten im wesentlichen zwei Effekte:
- Langzeiteffekte (Alterung), wie eine durch GammaStrahlung erzeugte Verschiebung von Arbeitspunkten, oder eine Einlagerung geladener Teilchen in einen Chip. Diese Effekte sind jedoch in vielen Fällen tolerierbar bzw. kompensierbar.
- Plötzliche Effekte (Single Event Effects, SEE), wie "Umkippen" einzelner Bits in digitalen Schaltungen, Entstehen kurzer Pulse in analogen Schaltungen oder bei CMOS-Schaltungskomponenten auftretende sogenannte Latch-Ups.
- Letztere werden dadurch verursacht, dass ionisierende Teilchen, beispielsweise Alpha-, Beta-, Schwerionen- oder Protonenstrahlung, die parasitär in dem CMOS-Substrat enthaltenen Thyristoren zünden, was einen schnellen Stromanstieg und - ohne Schutzmaßnahmen - eine Zerstörung der Schaltungskomponente zur Folge hat.

Bisherige Konzepte beschränken sich darauf, die Stromaufnahme einer Schaltung zu messen und abzuschalten, wenn die Stromaufnahme einen eingestellten Sollwert übersteigt; dadurch wird/werden der/die parasitäre/n Thyristor/en gelöscht. Ferner sind auch Schutzschaltungen gebräuchlich, mit welchen nur eine Strombegrenzung vorgenommen wird. (Siehe beispielsweise die Veröffentlichung "Active input filter" von Giulio Simonelli und Philippe Perol, S. 1-6.)

Die bisher eingesetzten Schaltungen haben folgende Nachteile. Eventuelle zur Filterung der Betriebsspannung in der zu schützenden Schaltung vorhandene Kondensatoren entladen sich beim Auftreten eines Latch-Up über den parasitären Thyristor; dies macht eine Zerstörung der jeweils betroffenen Schaltungskomponenten noch wahrscheinlicher, da beispielsweise in einem Chip mehr Energie auf engstem Raum in Wärme umgesetzt wird.

Ferner fallen Schaltungskomponenten mit einer im Vergleich zu anderen Schaltungskomponenten geringeren Stromaufnahme, in welchen ein Latch-Up ausgelöst wird, neben Schaltungskomponenten mit einer höheren Stromaufnahme in der Schaltung nicht auf, so dass auch keine rechtzeitige Abschaltung vorgenommen wird bzw. werden kann.

Schaltungen mit veränderlicher oder pulsartiger Stromaufnahme können ohnehin nur unzureichend geschützt werden. Ein Spannungsabfall an einem Strom-Messwiderstand führt dazu, dass die zu schützende Schaltung mit weniger als der Nominalspannung versorgt wird, insbesondere dann, wenn deren Stromaufnahme stark schwankt, und somit eine Primärspannungserhöhung zur Kompensation nicht in Frage kommt.

### Beschreibung der Erfindung

Aufgabe der Erfindung ist es, ein Verfahren zum Löschen von Latch-Ups anzugeben, mit welchem die Nachteile und Beschränkungen der bisher angewendeten Maßnahmen beseitigt sind. Um eine Konvertierung strahlungsempfindlicher Schaltungsdesigns bei Anwendungen mit einer Einwirkung hoher Strahlendosen zu ermöglichen, ist es ferner Aufgabe der Erfindung, ein Spannungsversorgungskonzept anzugeben, mit welchem konventionelle, nicht strahlungsresistente Schaltungskomponenten vor einer Zerstörung bei Auftreten eines Latch-Up geschützt sind.

Gemäß der Erfindung wird diese Aufgabe bei einem Verfahren zum Löschen von Latch-Ups nach dem Oberbegriff des Anspruchs 1 dadurch gelöst, dass die in der Schaltung befindliche Ladung mittels eines Kurzschlussschalters abgebaut wird und beim Wiederhochfahren der Versorgungsspannung eine Unterspannungsdetektion kurzzeitig unterdrückt wird. Nach Ablauf der Entladezeit wird somit die zu schützende Schaltung wieder mit Spannung versorgt. Hierbei verhindert ein Zeitglied, das die Unterspannungsdetektion unterdrückt, ein fälschliches Auslösen der Schutzschaltung beim Hochfahren.

Ferner wird bei einer Anordnung zum Durchführen des Verfahrens nach Anspruch 1 zum Schutz von strahlungsempfindlichen aktiven Schaltungselementen einer elektronischen Schaltung die elektronische Schaltung in Gruppen von aktiven Schaltungskomponenten mit in einem vorgegebenen Bereich ähnlich großer Stromaufnahme unterteilt. Hierbei ist mindestens einer dieser Gruppen von aktiven Schaltungskomponenten mit in einem vorgegebenen Bereich ähnlich großer Stromaufnahme eine Schutzschaltung zugeordnet.

Das erfindungsgemäße Konzept geht somit über ein bisher übliches, einfaches Abschalten bei Überschreiten bestimmter Spannungs- oder Stromwerte hinaus. Gemäß dem Grundgedanken der Erfindung wird die zu schützende elektronische Schaltung in kleine, vorzugsweise möglichst kleine Gruppen von Schaltungskomponenten mit ähnlicher, d.h. in einem vorgegebenen Bereich annähernd gleich großer Stromaufnahme aufgeteilt, damit ein Latch-Up in Schaltungskomponenten bzw. Gruppen von Schaltungskomponenten mit im Vergleich zu anderen Schaltungskomponenten geringeren Stromaufnahme eindeutig von normalen Änderungen im Versorgungsstrom einer Schaltungskomponente bzw. Gruppen von Schaltungskomponenten mit einer höheren, gegebenenfalls erheblich größeren Stromaufnahme unterschieden werden kann.

Gemäß der Erfindung ist hierzu für jede dieser Gruppen von Schaltungskomponenten mit einer ähnlichen, d.h. in einem vorgegebenen Bereich annähernd gleich großen Stromaufnahme über eine - an die Versorgungsspannung und Stromaufnahme der jeweiligen Gruppe angepasste - Schutzschaltung vorgesehen, die einen abschaltbaren Spannungsregler mit einstellbarer Strombegrenzung, ein Stellglied, einen Vergleicher zur Detektion von Unterspannung, zwei Monoflops, einen Kurzschlussschalter mit Strombegrenzung und am Ausgang mindestens einen Kondensator aufweist.

Um einen Einfluss des Ausgangsstroms auf die Ausgangsspannung zu vermeiden, ist die Einheit zur Stromdetektierung vor einer Einheit zur Spannungsregelung angeordnet.

Gemäß einer vorteilhaften Ausgestaltung der Erfindung sind zum Abschalten von mehreren oder allen Gruppen von aktiven Schaltungskomponenten, welchen jeweils eine Schutzschaltung zugeordnet ist, eine Signalisierungsleitung und eine Steuerleitung vorgesehen, welche die Schultzschaltungen der zusammengefassten Gruppen von aktiven Schaltungskomponenten ausgangsseitig verbinden. Hierzu sind die Signalleitungen und die Steuerleitung mit einem zentralen Monoflop verbunden.

Hierdurch ist erreicht, dass, sobald ein Latch-Up in einer Gruppe von einer der Schutzschaltungen detektiert wird, die Signalisierungsleitung gesetzt und dadurch das zentrale Monoflop gestartet wird. Durch das zentrale Monoflop werden dann über die Steuerleitung alle Spannungsregler der einzelnen Schutzschaltungen ausgeschaltet und alle Kurzschlussschalter dieser Schutzschaltungen aktiviert. Nach einer vorgegebenen kurzzeitigen Einschaltverzögerung wird durch jeweils in mehreren oder allen Gruppen von aktiven Schaltungskomponenten einer elektrischen Schaltung die Versorgungsspannung wieder eingeschaltet und dadurch die gesamte zu schützende elektronische Schaltung wieder hochgefahren.

### Beschreibung der Zeichnungen

Es zeigen:
- Fig.1: eine Schaltungstopologie mit einer Latch-Up-Detektion;
- Fig.2: eine Ausführungsform einer Schutzschaltung zum Schutz einer Gruppe von Schaltungskomponenten, und
- Fig.3: eine Schaltungsanordnung zum Schutz von mehreren Gruppen von Schaltungskomponenten.

### Beschreibung der Erfindung

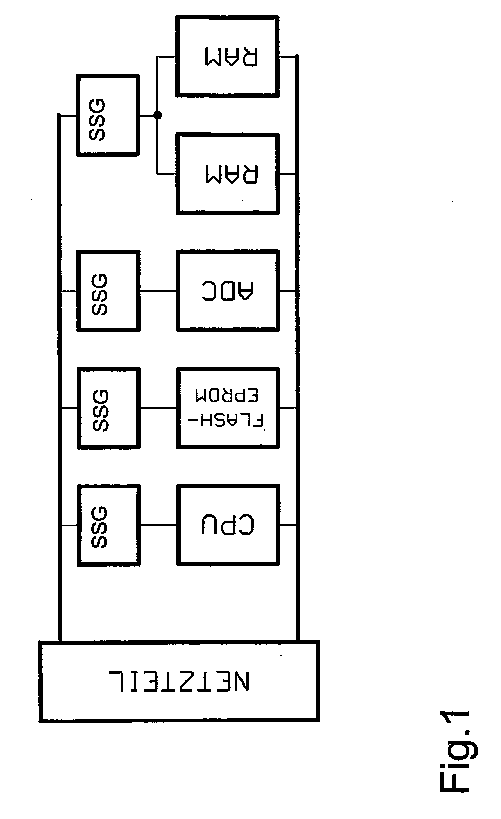

Entsprechend dem erfindungsgemäßen Konzept, eine zu schützende elektronische Schaltung in vorzugsweise möglichst kleine Gruppen von Schaltungskomponenten mit ähnlicher, d.h. in einem vorgegebenen Bereich annähernd gleich großer Stromaufnahme zu unterteilen, ist in Fig.1 ein Beispiel einer Schaltungstopologie schematisiert dargestellt. In dem wiedergegebenen Beispiel werden von einem Netzteil ein Zentralrechner CPU sowie beispielsweise ein Flash-Eprom, ein Analog-Digital-Wandler ADC sowie beispielsweise zwei RAM-Speicher mit Strom versorgt.

Gemäß der Erfindung ist jeder der vorstehend als Beispiel angeführten Schaltungskomponenten CPU bis RAM eine Schutzschaltung SSG zugeordnet. Auf diese Weise kann ein Latch-Up in einer der Schaltungskomponenten mit einer verhältnismäßig kleinen Stromaufnahme eindeutig und zuverlässig von beispielsweise einer Änderung im Versorgungsstrom einer Schaltungskomponente mit einer erheblich größeren Stromaufnahme unterschieden werden.

Sobald daher in einer der angeschlossenen Schaltungskomponenten ein Latch-Up auftritt, steigt in der betroffenen Schaltungskomponente die Stromaufnahme entsprechend an, worauf ein in der zugeordneten Schutzschaltung vorgesehener Stromregler eingreift und den Stromfluss in die angeschlossene Schaltungskomponente begrenzt. Dadurch sinkt die Spannung am Ausgang unter eine vorgegebene Toleranzschwelle, so dass die Abschaltung der Versorgungsspannung stattfindet und beispielsweise, was nachstehend im einzelnen noch näher ausgeführt wird, ein nachgeordneter Kurzschlussschalter aktiviert wird. Dadurch erfolgt innerhalb weniger Mikrosekunden ein Sperren des Stroms. Beispielsweise wird ein durch ein Latch-Up gezündeter parasitärer Thyristor somit vor der Zerstörung der jeweiligen Schaltungskomponente gelöscht.

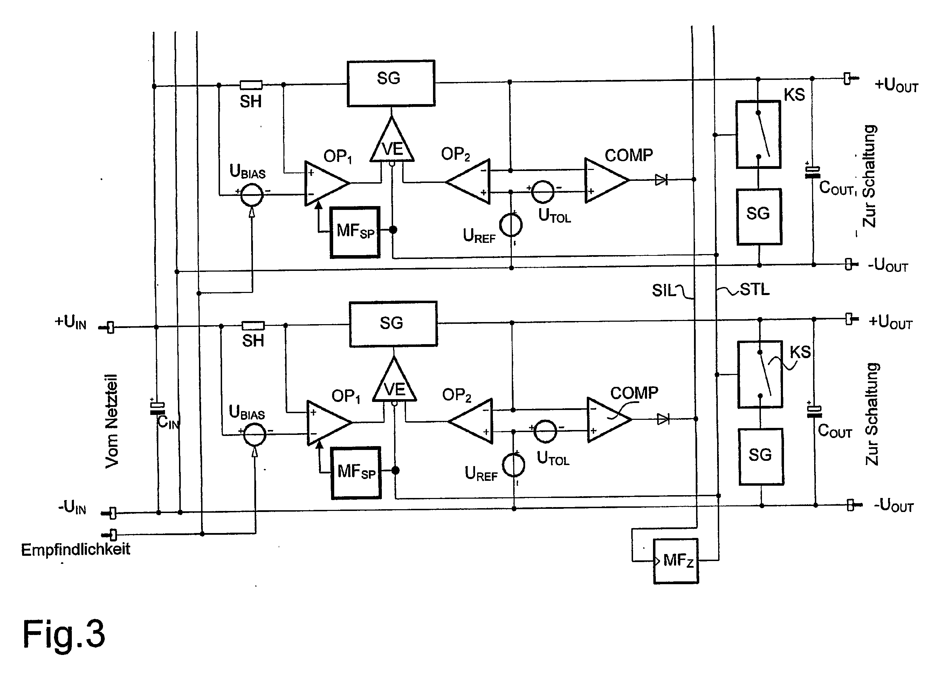

Gemäß der Erfindung kann eine einzelne von dem Latch-Up betroffene Gruppe von Schaltungselementen abgeschaltet werden oder gemäß einer vorteilhaften Weiterbildung der Erfindung können beim Auftreten eines Latch-Up in einer Gruppe von Schaltungselementen auch mehrere oder vorteilhafterweise auch alle Gruppen von Schaltungskomponenten einer elektronischen Schaltung ausgeschaltet und nach einer kurzzeitigen Verzögerung wieder eingeschaltet werden, was nachstehend anhand von Fig.3 im einzelnen näher erläutert wird.

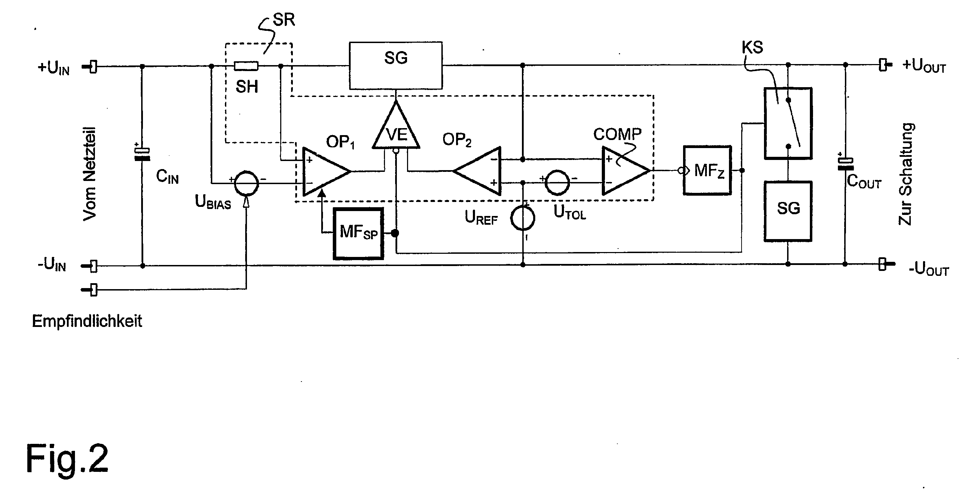

Wie in Fig.2 dargestellt, weist eine Schutzschaltung SSG zur Glättung der Versorgungsspannung einen Filterkondensator C_{IN}, einen abschaltbaren linearen Spannungsregler SR mit einstellbarer Strombegrenzung, einen Komparator COMP zur Unterspannungsdetektion, zwei Monoflops MF_{SP} und MF_{Z} einen Kurzschlussschalter KS mit vorgeschaltetem Strombegrenzer SG und einen Kondensator C_{OUT} am Ausgang auf. Hierbei kann der Spannungsregler SR beispielsweise zwei Operationsverstärker OP₁, OP₂, ein Shunt SH und ein Verstärkerelement VE aufweisen.

Die von einem Netzteil kommende ungeregelte Spannung U_{IN} wird zunächst mittels des Filterkondensators C_{IN} geglättet. Mittels des Shunt SH wird eine dem Stromfluss proportionale Spannung erzeugt. Im Normalbetrieb der angeschlossenen Schaltung ist diese Spannung kleiner als U_{BIAS}, weswegen der Operationsverstärker OP₁ (Strombegrenzung) des Spannungsreglers SR nicht in die Regelung eingreift. Mittels des Operationsverstärkers OP₂ wird die Ausgangsspannung mit einer vorgegebenen Sollspannung U_{REF} verglichen und mittels des Stellglieds SG, das ein bipolarer oder strahlungsfester Feldeffekttransistor sein kann, solange nachgeregelt, bis die Ausgangsspannung U_{OUT} gleich einer Referenzspannung U_{REF} ist.

Tritt nun in einer angeschlossenen Schaltungsgruppe ein Latch-Up auf, so steigt die Stromaufnahme solange an, bis die Spannung am Shunt SH gleich der Spannung U_{BIAS} ist. Damit greift die Strombegrenzung in die Spannungsregelung ein und begrenzt den Stromfluss in die angeschlossene Schaltungsgruppe. Dadurch sinkt die Spannung am Ausgang soweit ab, dass sie unter eine Toleranzschwelle (U_{REF} - U_{TOL}) fällt und dadurch den Komparator COMP auslöst. Der Komparator COMP sperrt mit Hilfe des Verstärkungselements VE den Strom und aktiviert den Kurzschlussschalter KS.

Der Kurzschlussschalter KS entlädt innerhalb weniger Mikrosekunden den Kondensator C_{OUT} am Ausgang und alle Kapazitäten, welche in der zu schützenden Schaltung selbst die Betriebsspannung stützen. Durch den Strombegrenzer SG ist der Kurzschlussschalter KS geschützt. Das Monoflop MF_{Z} begrenzt die Abschaltzeit auf einige Millisekunden und sorgt so für eine automatische Rückstellung und ein Wiederanlaufen der Versorgungsspannung. Beim Wiederanlaufen der Versorgungsspannung sorgt das Monoflop MF_{SP}, welches die Unterspannungsdetektion unterdrückt, dafür, dass nicht fälschlicherweise eine Latch-Up-Detektion ausgelöst wird.

Durch das kurzzeitige Abschalten der Versorgungsspannung für die angeschlossene Gruppe von Schaltungskomponenten wird der durch ein Latch-Up gezündete parasitäre Thyristor vor der Zerstörung des betroffenen Bauteils wieder gelöscht. Die Schaltung wird anschließend wieder neu gestartet.

Die vorstehend beschriebene Schaltung wird eingesetzt, wenn beim Auftreten eines Latch-Up nur eine einzelne Gruppe von Schaltungskomponenten abgeschaltet und vollkommen entladen werden soll. Häufig wird nicht nur gewünscht, sondern ist es im allgemeinen auch sehr zweckmäßig und sinnvoll, dass beim Auftreten eines Latch-Up in einer Gruppe von Schaltungskomponenten mehrere oder alle Gruppen von Schaltungselementen einer elektronischen Schaltung aus- und wieder eingeschaltet werden, um Querströme zu vermeiden. Beispielsweise soll in einer Prozessorschaltung ein Latch-Up in einem Speicherbaustein zu einem Abschalten und einem Wiederanlaufen des Prozessors führen.

In diesem Fall kommt folgende unter Bezugnahme auf Fig.3 beschriebene Topologie zur Anwendung:

Im Unterschied zum Abschalten einer einzelnen Gruppe von Schaltungskomponenten sind zum Abschalten von mehreren oder allen Gruppen von Schaltungskomponenten einer elektronischen Schaltung ausgangsseitig eine Signalisierungsleitung SIL und eine Steuerleitung STL vorgesehen, welche die einzelnen Schutzschaltungen SSG der Gruppen von Schaltungskomponenten verbinden, und welche mit einem zentralen Monoflop MF_{Z} verbunden sind.

Detektiert eine der Schutzschaltungen SSG einen Latch-Up, so setzt diese Schutzschaltung SSG die Signalisierungsleitung SIL. Dadurch wird das zentrale Monoflop MF_{Z} gestartet, das über die Steuerleitung STL wiederum alle Spannungsregler SR ausschaltet und alle Kurzschlussschalter KS aktiviert. Anschließend wird durch jeweils in mehreren oder allen Gruppen von aktiven Schaltungskomponenten einer elektrischen Schaltung vorgesehene Monoflops (MF_{SK}) die Versorgungsspannung wieder hochgefahren.

Die gemäß der Erfindung mehreren oder allen Gruppen von Schaltungskomponenten einer elektronischen Schaltung zugeordneten Schutzschaltungen SSG weisen gegenüber den aus dem Stand der Technik bekannten "Schutzschaltungen" folgende Vorteile auf:
- Eine Integration der Schutzschaltungen SSG ist einfach und platzsparend möglich, da ein Spannungsreglerbaustein verwendet werden kann, welcher abschaltbar ist und bereits Spannungs- und Stromregler, sowie Unterspannungsdetektion enthält.
- Die Schwelle, ab welcher eine Strombegrenzung erfolgt, kann von außen durch eine analoge Spannung eingestellt werden. Dadurch kann die Schutzschwelle nachgestellt werden, wenn die normale Stromaufnahme der zu schützenden Gruppe von Schaltungskomponenten (wegen durch Bestrahlung auftretender höherer Leckströme) während der Einsatzdauer angestiegen ist.
- Pulsweise auftretende Ströme, wie sie Digitalschaltungen erzeugen, werden von einem entsprechend dimensionierten Filterkondensator am Ausgang gepuffert, so dass solche pulsweise auftretenden Ströme nicht zur Auslösung einer der Schutzschaltungen führen kann.
- Der Spannungsabfall am Strommesswiderstand wird ausgeregelt, sodass der angeschlossenen Schaltung unabhängig von der Stromaufnahme immer eine konstante Spannung zur Verfügung steht.
- Bestimmungsgemäß entlädt der Kurzschlussschalter KS alle angeschlossenen Kondensatoren, sodass die hier gespeicherte Energie nicht im parasitären Thyristor der betroffenen Schaltungskomponente vernichtet werden muss.
- Diese Verkopplung vermeidet die Entstehung von Querströmen in komplexen elektrischen Schaltungen durch die gleichzeitige Aktivierung aller Schutzschaltungen.

## Patentansprüche

1. Verfahren zum Löschen von in einer Schaltung auftretenden Latch-Ups, wobei bei strombegrenzter Versorgungsspannung eine Unterspannung detektiert wird, nach Detektieren eines Latch-Up die Versorgungsspannung abgeschaltet und in der Schaltung befindliche Ladung abgebaut wird, wobei die in der Schaltung befindliche Ladung mittels eines Kurzschlussschalters abgebaut wird, **dadurch gekennzeichnet, daß** beim Wiederhochfahren der Versorgungsspannung eine Unterspannungsdetektion kurzzeitig unterdrückt wird.

2. Anordnung zum Durchführen der Verfahren nach Anspruch 1 zum Schutz von strahlungsempfindlichen aktiven Schaltungskomponenten einer elektronischen Schaltung **dadurch gekennzeichnet, dass** die elektronische Schaltung in Gruppen von aktiven Schaltungskomponenten mit in einem vorgegebenen Bereich ähnlich großer Stromaufnahme unterteilt ist, und mindestens einer dieser Gruppen von aktiven Schaltungskomponenten mit in einem vorgegebenen Bereich annähernd gleich großer Stromaufnahme eine Schutzschaltung (SSG) zugeordnet ist.

3. Anordnung nach Anspruch 2, **dadurch gekennzeichnet, dass** die Schutzschaltung einen abschaltbaren Spannungsregler (SR) mit einstellbarer Strombegrenzung, ein Stellglied (SG), einen Vergleicher (COMP) zur Detektion von Unterspannung, zwei Monoflops (MF_{Z} und MF_{SK}), einen Kurzschlussschalter (KS) mit Strombegrenzung und am Ausgang mindestens einen Kondensator (C_{OUT}) aufweist.

4. Anordnung nach Anspruch 2 oder 3, **dadurch gekennzeichnet, dass** eine Einheit zur Stromdetektierung vor einer Einheit zur Spannungsregelung angeordnet ist, um so einen Einfluss des Ausgangsstroms auf die Ausgangsspannung zu vermeiden.

5. Anordnung nach einem der Ansprüche 2 bis 4, **dadurch gekennzeichnet, dass** zum Abschalten von mehreren oder allen Gruppen von aktiven Schaltungskomponenten einer elektronischen Schaltung, denen jeweils eine Schutzschaltung (SSG) zugeordnet ist, eine Signalisierungsleitung (SIL) und eine Steuerleitung (STL) vorgesehen sind, welche die Schutzschaltungen (SSG) der Gruppen von aktiven Schaltungskomponenten ausgangsseitig verbinden und ihrerseits mit einem zentralen Monoflop (MF_{Z}) verbunden sind, so dass bei Detektion eines Latch-Up in einer der Schutzschaltungen (SSG) über die Signalisierungsleitung (SIL) das zentrale Monoflop (MF_{Z}) gestartet wird, worauf über die Steuerleitung (STL) alle Spannungsregler (SR) ausgeschaltet und alle Kurzschlussschalter (KS) der Schutzschaltungen (SSG) aktiviert werden und nach einer vorgegebenen kurzzeitigen Verzögerung durch jeweils in mehreren oder allen Gruppen von aktiven Schaltungskomponenten einer elektrischen Schaltung vorgesehene Monoflops (MF_{SK}) die Versorgungsspannung wieder hochgefahren wird.

## Claims

1. A method for suppressing latch-ups occurring in a circuit, wherein, in a current-limited supply voltage, an undervoltage is detected, the supply voltage is switched off following the detection of a latch-up, and charge located in the circuit is reduced, whereby the charge existing in the circuit is reduced by a short-circuiting switch **characterized in that** during restoration of the supply voltage, an undervoltage detection is suppressed for a short time.

2. A system for performing the methods according to claim 1 for protection of radiation-sensitive active circuit components of an electronic circuit, **characterized in that** the electronic circuit is subdivided into groups of active circuit components with substantially the same current consumption in a predefined area, and at least one of these groups of active circuit components with substantially the same current consumption in a predefined area has a protective circuit (SSG) assigned to it.

3. The system according to claim 2, **characterized in that** the protective circuit comprises a voltage controller (SR) adapted to be switched off and allowing for adjustment of the current limitation, a actuator (SG), a comparator (COMP) for detection of undervoltage, two monoflops (MF_{Z} and MF_{SK}), a short-circuiting switch (KS) with current limitation and, at the output, at least one capacitor (C_{OUT}).

4. The system according to claim 2 or 3, **characterized in that** a unit for current detection is arranged upstream of a unit for voltage control to thereby avoid an influence of the output current on the output voltage.

5. The system according to any one of claims 2 to 4, **characterized in that**, for switching off a plurality or all of the groups of active circuit components of an electronic circuit having respectively one protective circuit (SSG) assigned thereto, a signaling line (SIL) and a control line (STL) are provided which connect the protective circuits (SSG) of the groups of active circuit components on the output side and which themselves are connected to a central monoflop (MF_{Z}), so that, upon detection of a latch-up in one of the protective circuits (SSG), the central monoflop (MF_{Z}) is started via the signaling line (SIL) whereupon, via the control line (STL), all voltage controllers (SR) are switched off and all short-circuiting switches (KS) of the protective circuits (SSG) are activated and, after lapse of a predetermined brief delay, the supply voltage is restored again by monoflops (MF_{SK}) respectively provided in a plurality or all groups of active circuit components of an electronic circuit.

## Revendications

1. Procédé pour effacer les latch-ups ou déclenchements parasites apparaissant dans un circuit, dans lequel, pour une tension d'alimentation limitée en intensité, une sous-tension est détectée, après détection d'un latch-up ou déclenchement parasite, la tension d'alimentation est mise hors circuit et la charge se trouvant dans le circuit est réduite, dans lequel la charge se trouvant dans le circuit est réduite au moyen d'un contacteur court-circuit, **caractérisé en ce que**, pour une remontée de la tension d'alimentation, une détection de sous-tension est brièvement inhibée.

2. Dispositif pour réaliser le procédé selon la revendication 1 pour la protection de composants de circuits actifs sensibles au rayonnement d'un circuit électronique, **caractérisé en ce que** le circuit électronique est divisé en groupes de composants de circuits actifs avec une absorption de courant de grandeur similaire dans une zone prédéterminée, et à au moins un de ces groupes de composants de circuits actifs avec une absorption de courant approximativement de même grandeur dans une zone préétablie est affecté un circuit de protection (SSG).

3. Dispositif selon la revendication 2, **caractérisé en ce que** le circuit de protection comporte un régulateur de tension (SR) pouvant être mis hors circuit avec une limitation de courant réglable, un élément de réglage (SG), un comparateur (COMP) pour la détection de sous-tension, deux monoflops ou mono-vibrateurs (MF_{Z} et MF_{SK}), un commutateur court-circuit (KS) avec une limitation de courant et, à la sortie, au moins un condensateur (C_{OUT}).

4. Dispositif selon la revendication 2 ou 3, **caractérisé en ce qu'**une unité est prévue pour la détection de courant en amont d'une unité pour la régulation de tension, pour éviter l'incidence du courant de sortie sur la tension de sortie.

5. Dispositif selon l'une des revendications 2 à 4, **caractérisé en ce que**, pour la mise hors circuit de plusieurs ou de tous les groupes des composants de circuits actifs d'un circuit électronique, auquel est respectivement affecté un circuit de protection (SSG), sont prévues une ligne de signalisation (SIL) et une ligne de commande (STL) qui relient, sur le côté sortie, les circuits de protection (SSG) des groupes de composants de circuits actifs et sont, de leur côté, raccordées à un monoflop ou mono-vibrateur central (MF_{Z}), de sorte que lors de la détection d'un latch-up ou déclenchement parasite dans l'un des circuits de protection (SSG) par le biais de la ligne de signalisation (SIL), le monoflop ou mono-vibrateur central est mis en route, après quoi, par le biais de la ligne de commande (STL), tous les régulateurs de tension (SR) sont mis hors circuit et tous les commutateurs courts-circuits (KS) des circuits de protection (SSG) sont activés et, après une temporisation brève préétablie, la tension d'alimentation est remontée respectivement dans plusieurs ou dans tous les groupes des composants de circuits actifs d'un circuit électrique du monoflop ou mono-vibrateur prévu (MF_{SK}).
